# EUROPEAN PATENT APPLICATION

(11) **EP 4 379 816 A1**
(43) Date of publication of application: **05.06.2024**
(21) Application number: 23855832.4
(22) Date of filing: 28.08.2023
(51) Int. Cl.: H01L 31/0352, H01L 31/0216, H01L 31/0288, H01L 31/068, H01L 31/18

(54) **SOLAR CELL AND MANUFACTURING METHOD THEREFOR**

(30) Priority: 23.09.2022 CN 202211170399
(71) Applicant: Tongwei Solar (Meishan) Co., Ltd., Meishan, Sichuan 620041 (CN)
(72) Inventor: CHEN, Hao, Meishan Sichuan 620041 (CN); XING, Guoqiang, Meishan Sichuan 620041 (CN)
(74) Representative: Marks & Clerk LLP
(86) International application number: PCT/CN2023/115160
(87) International publication number: WO 2024/060933

(57) **Abstract**

The embodiments of the present application relate to the field of solar cells, and provide a solar cell and a preparation method thereof. The solar cell includes: a P-type silicon wafer; a plurality of P-type heavily-doped layers, a front passivation layer, a front anti-reflection layer, and a plurality of front metal gate lines, sequentially disposed on a front surface of the P-type silicon wafer; and a doped oxide layer, a back crystalline silicon layer, a back anti-reflection layer, and a back metal electrode layer, sequentially disposed on a back surface of the P-type silicon wafer. The plurality of P-type heavily-doped layers are disposed in a plurality of regions corresponding to the plurality of front metal gate lines, respectively, and each of the plurality of front metal gate lines sequentially passes through the front passivation layer, and the front anti-reflection layer to form contact with a corresponding one of the plurality of P-type heavily-doped layer. The solar cell of the embodiments of the present application has a simple structure, a short process time, a high production capacity, and a high conversion efficiency.

## Description

This application claims priority to Chinese Patent Application No. 202211170399.9 entitled "SOLAR CELL AND PREPARATION METHOD THEREFOR" filed with the Chinese Patent Office on September 23, 2022, which is hereby incorporated by reference in its entirety.

### TECHNICAL FIELD

The present application relates to the field of solar cells, and in particular to a solar cell and a preparation method thereof.

### BACKGROUND

The tunnel oxide passivated contact (TOPCon) cell has a high efficiency limit which is approximate to the theoretical limit efficiency of the crystalline silicon solar cell. Generally, the fully-covering boron-diffusion process is applied to the front of the TOPCon cell to from the PN junction on the front, which is adapted to the high-temperature metallization process, reduces the metal recombination protection open-circuit voltage, forms the contact, and provides the transverse transmission function that facilitates the current collection. Besides, in the monocrystalline silicon solar cell such as the TOPCon cell, the carrier recombination at the interface of the fully-covering boron-diffused front-emitter electrode is relatively high, generally 20-40 fAcm⁻², which limits the passivation performance and the open-circuit voltage of the cell, and further results in a relatively low cell efficiency. Therefore, the carrier recombination at the interface is an important factor limiting the efficiency improvement of the solar cell.

Currently, in the industry, the method of preparing the fully-covering boron-diffused emitter electrode is generally selected to prepare the front structure of the N-type TOPCon cell. The boron diffusion is generally performed in a tubular device. Firstly, the tubular device is vacuumed and heated to an elevated temperature, and introduced with an inert gas carrying a certain flow of oxygen to perform a pre-oxidizing process and then an inert gas carrying a certain flow of boron source to perform a diffusion process. Thereafter, a post-oxidizing process is performed at an elevated temperature before cooling, removing the vacuum, and opening the device. Such prepared fully-covering boron-diffused emitter electrode has the following problems. (1) The Auger recombination in the region of the silicon substrate beneath the non-metal contact region (which is 95% or more of the cell region) is increased, the passivation performance on the front is weakened, and the recombination current at the interface is high, which is generally 20 to 40 fAcm⁻². (2) The boron diffusion process generally takes 2 to 4 hours, which is time consuming and limits the production capacity of the TOPcon cell.

### SUMMARY

The embodiments of the present application aim to provide a solar cell and a preparation method thereof, with a simple cell structure, a short process time, a high production capacity, and a high cell conversion efficiency.

In a first aspect, the embodiments of the present application provide a solar cell, including
a P-type silicon wafer;
a plurality of P-type heavily-doped layers, a front passivation layer, a front anti-reflection layer, and a plurality of front metal gate lines, which are sequentially disposed on a front surface of the P-type silicon wafer, wherein the plurality of P-type heavily-doped layers are disposed in a plurality of regions corresponding to the plurality of front metal gate lines, respectively, and each of the plurality of front metal gate lines sequentially passes through the front passivation layer, and the front anti-reflection layer to form contact with a corresponding one of the plurality of P-type heavily-doped layers; and
a doped oxide layer, a back crystalline silicon layer, a back anti-reflection layer, and a back metal electrode layer sequentially disposed on a back surface of the P-type silicon wafer.

In the above technical solution, a solution without the front electric field is adopted for the front of the TOPCon cell. That is, the P-type silicon wafer is selected to prepare the cell; and instead of a fully-covering boron-diffusion on the front of the cell, the boron heavily-doped regions are specifically provided beneath the respective front metal grid lines in order to reduce the surface recombination and form a good metal contact. As compared to the conventional N-type fully-covering boron-diffused TOPCon cell (partial regions beneath the metal grid lines are heavily-doped, i.e., overlapped with the selective emitter electrodes), the solar cell of the present application has at least three advantages as below.
1. The recombination at the interface and the Auger recombination in the silicon substrate in the non-metal contact region are reduced, so that the open-circuit voltage of the cell is significantly increased (by 5 mV or more).
2. As compared to the N-type fully-covering boron-diffused structure, although the P-type structure without the front electric field of the present application dose not contains the lightly-doped boron-diffused layer and thus the transverse transmission of the carriers caused thereby, the cell of the present application has an increased fill factor (FF) (increased by 1%, with the same resistivity (1Ωcm) of the silicon substrate). This is because the front passivation layer has a better passivation performance on the P-type silicon substrate (P-type silicon wafer) than that on the boron lightly-diffused N type silicon wafer, which facilitates the increase in iFF and in turn the increase in FF value after the metallization. The P-type silicon substrate has a very high hole conduction capability, and the resistance loss during the conduction of holes from a back PN junction to a front heavily-doped contact region through the silicon substrate is far less than the resistance loss during the transmission in the boron-diffused N-type silicon, which results in a higher FF value. As the resistance loss increases with the increase in the resistivity of the silicon substrate, the resistivity of the silicon substrate is preferred to be controlled at about 1 Ωcm.
3. The cost per watt of the cell of the present application is lower. The cost of the P-type silicon wafer is much lower than that of the N-type silicon wafer. The solution without the front electric field omits the fully-covering boron-diffusion process, so that the overall process is less time-consuming and has higher production capacity.

Therefore, in the present application, the cell structure is simple, and the process time is short. As there is no fully-covering emitter electrode on the front, the passivation performance and the corresponding open-circuit voltage are significantly improved. The quantum efficiency at the short wave and the short-circuit current are reduced. The conversion efficiency of the cell is high. As compared to the conventional N-type TOPCon cell, the cell of the present application has advantages of higher cell efficiency, lower cell cost, higher production capacity, and more cost-effective, which is beneficial for promoting the industrial progress of a high-efficiency double-sided TOPCon cell.

In one possible embodiment, the back metal electrode layer comprises a plurality of back metal gate lines sequentially passing through the back anti-reflection layer, the back crystalline silicon layer, and the doped oxide layer to form contact with the P-type silicon wafer.

In one possible embodiment, the p-type silicon wafer has a resistivity of 0.5 to 10 Qcm, and/or the P-type heavily-doped layers have a sheet resistance of 1-120 S2/sq.

In one possible embodiment, the front anti-reflection layer has a composition comprising at least one of silicon nitride, silicon oxynitride, or silicon oxide and a thickness of 1 to 150 nm; and/or the back anti-reflection layer has a composition comprising at least one of silicon nitride, silicon oxynitride, or silicon oxide and a thickness of 1 to 100 nm.

In one possible embodiment, the front passivation layer has a composition comprising at least one of aluminum oxide or silicon oxide and a thickness of 1 to 40 nm.

In one possible embodiment, the doped oxide layer has a composition comprising silicon oxide and a thickness of 1 to 2 nm.

In one possible embodiment, the back crystalline silicon layer has a composition comprising polycrystalline silicon or amorphous silicon and a thickness of 1 to 200 nm.

In a second aspect, the embodiments of the present application provide a method for preparing the solar cell according the first aspect, comprising steps of:
sequentially forming the plurality of P-type heavily-doped layers, the front passivation layer, the front anti-reflection layer, and the plurality of front metal gate lines on the front surface of the P-type silicon wafer, and
sequentially forming the doped oxide layer, the back crystalline silicon layer, the back anti-reflection layer, and the back metal electrode layer on the back surface of the P-type silicon wafer.

In the above technical solution, the TOPCon cell in the present application is prepared by using the P-type silicon wafer instead of the N-type silicon wafer, so that the price of the silicon wafer is lower, and the cost per watt is reduced. One step of boron diffusion is omitted in the preparation process, so that the time period of the cell preparation process is reduced by 2 hours or more, and the costs of the corresponding auxiliary materials and devices are reduced.

In one possible embodiment, the P-type heavily-doped layers are formed by laser doping of boron, boron-paste printing doping, or laser film-cutting boron-diffusion doping.

In one possible embodiment, the front metal gate lines are formed in a partially burning-through contact manner, and/or the back metal electrode layer is formed in a partially burning-through contact manner or a fully covering manner.

### BRIEF DESCRIPTION OF THE DRAWINGS

To describe the technical solutions of the present application more clearly, the following briefly introduces the accompanying drawings used in the present application. Apparently, the accompanying drawings in the following description show merely some embodiments of the present application, and persons of ordinary skill in the art may still derive other drawings from the accompanying drawings without creative efforts.

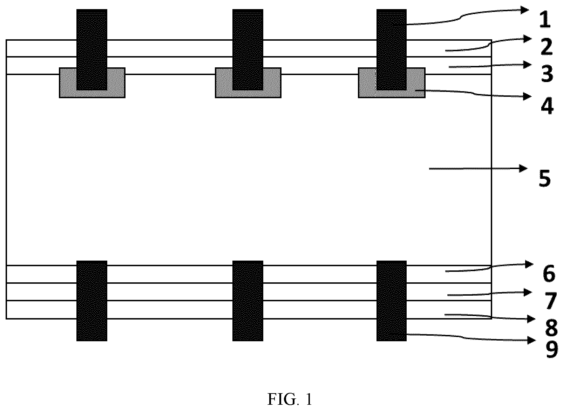

FIG. 1 is a schematic structural view of a P-type TOPCon cell provided according to embodiments of the present application.

Reference signs: 1. front metal gate line; 2. front anti-reflection layer; 3. front passivation layer; 4. P-type heavily-doped layer; 5. P-type silicon wafer; 6. doped oxide layer; 7. back crystalline silicon layer; 8. back anti-reflection layer; and 9. back metal gate line.

### DETAILED DESCRIPTION OF THE EMBODIMENTS

In order to facilitate an understanding of the present application, the present application will now be described more fully hereinafter with reference to the accompanying drawings. Preferred embodiments of the present application are shown in the drawings. The present application may, however, be embodied in many different forms and is not limited to the embodiments described herein. On the contrary, the purpose of providing these embodiments is to provide a more thorough and comprehensive understanding of the disclosure of the present application.

Unless defined otherwise, all technical and scientific terms used herein have the same meaning as commonly understood by one of ordinary skill in the art to which the present application belongs. The terminology used herein in the description of the present application is for the purpose of describing particular embodiments only and is not intended to be limiting of the present application. The term "and/or" used herein includes any and all combinations of one or more related listed items.

The following has been found by the applicant. In current TOPCon cell, the P-type compound (the boron source) is doped into the silicon wafer at a high temperature to form the boron concentration. The boron concentration in the silicon wafer changes with the entry depth into the silicon wafer, typically exhibits a peak (highest value) at the surface area and decreases as the entry depth increases. A doping profile suitable for preparing the solar cell can be obtained by controlling parameters such as the amount of the boron source, the temperature, and the time. The doped silicon wafer has a PN junction formed at the interface between the front P-type doped silicon and the silicon substrate, with the built-in electric field having a direction pointing from the inside to the outside. The boron-diffused emitter electrode has a better shortwave response to lights than the bare silicon wafer, allowing the cell to have a higher quantum conversion efficiency in the short-wave band and a higher short-circuit current. The TOPCon cell typically adopts the metallization process by high-temperature sintering, during which the printed silver grid lines may be burned, enter the interior of the cell, and passes through the aluminum oxide layer or reach the vicinity of the aluminum oxide layer, forming a contact structure with the cell at the high temperature. The doping of boron at a high concentration is conducive to the good contact between the emitter electrode and silver particles, the output of the current, and the reduction in loss of the open-circuit voltage resulted from the recombination of carriers. Generally, the higher the boron doping concentration, the lower the metal recombination. The contact resistance between the silver paste and the bare silicon is relatively large, and doping with a certain concentration of boron facilitates the reduction of the contact resistance to a normal range. The carriers on the front of the cell are transferred along a path of transverse transmission in the silicon substrate and the boron-diffused emitter electrode before they are collected by the metal electrode. The lower the doping concentration of the boron-diffused emitter electrode, the higher the sheet resistance of the boron-diffused emitter electrode, the higher the resistance loss in the carrier transmission, the higher the series resistance of respective cells, and the lower the filling coefficient and the conversion efficiency.

Applicants have sought to address the above-described technical problems by modifying the boron-diffused emitter electrode of the TOPCon cell.

The following describes the technical solutions in the embodiments of the present application with reference to the accompanying drawings in the embodiments of the present application.

### First embodiment

Referring to FIG. 1, the present embodiment provides a P-type TOPCon cell, comprising: a P-type silicon wafer 5; a plurality of P-type heavily-doped layers 4, a front passivation layer 3, a front anti-reflection layer 2, and a plurality of front metal gate lines 1, which are sequentially disposed on a front surface of the P-type silicon wafer 5; and a doped oxide layer 6, a back crystalline silicon layer 7, a back anti-reflection layer 8, and a plurality of back metal gate lines 9, which are sequentially disposed on a back surface of the P-type silicon wafer 5. The plurality of P-type heavily-doped layer 4 is arranged in a plurality of regions corresponding to the plurality of front metal gate lines, respectively. Each of the plurality of front metal gate lines sequentially passes through the front anti-reflection layer 2 and the front passivation layer 3 to form contact with a corresponding one of the plurality of P-type heavily-doped layers 4. Each of the plurality of back metal gate lines 9 sequentially passes through the back anti-reflection layer 8, the back crystalline silicon layer 7, and the doped oxide layer 6 to form contact with the P-type silicon wafer 5. The PN junction of the cell is located between the doped oxide layer 6 on the back surface and the P-type silicon wafer 5. In an alternative embodiment, a back metal electrode layer covering the whole back anti-reflection layer 8 is used instead of the plurality of back metal gate lines 9.

In the embodiment of the present application, the resistivity of the P-type silicon 5 can be in the range of 0.5 to 10 Ωcm.

At the front of the P-type silicon wafer 5, the front surface of the P-type silicon wafer 5 has a textured morphology. Instead of the fully-covering emitter electrode, the boron-diffused heavily-doped regions (P++), i.e., the P-type heavily-doped layers 4, are disposed only in partial regions beneath the metal contact regions. The sheet resistance of the P-type heavily-doped layer 4 (the metal contact region) can be in the range of 1 to 120 S2/sq. The sheet resistance of the noncontact region is the sheet resistance of the P-type silicon wafer 5. The front anti-reflection layer 2 has a composition including, but not limited to, any one or a combination of any two or three of silicon nitride (SiNₓ), silicon oxynitride (SiOₓN_{y}), and silicon oxide (SiOₓ), and a thickness in the range of 1 to 150 nm. The front passivation layer 3 has a composition including, but not limited to, aluminum oxide (AlOₓ), silicon oxide (SiOₓ), or a combination thereof, and a thickness in the range of 1 to 40 nm.

At the back of the P-type silicon wafer 5, the doped oxide layer 6 has a composition including, but not limited to, silicon oxide (SiOₓ), and a thickness in the range of 1 to 2 nm. The back crystalline silicon layer 7 can be a polycrystalline silicon layer or an amorphous silicon layer, which has a composition including, but not limited to, Si, and a thickness in the range of 1 to 200 nm. The back anti-reflection layer 8 has a composition including, but not limited to, any one of or a combination of any two or three of silicon nitride (SiNₓ), silicon oxynitride (SiOₓN_{y}), and silicon oxide (SiOₓ), and a thickness in the range of 1 to 100 nm.

The front structure provided in the present application can reduce the recombination current in the front non-metal contact region from 20-40 fA/cm² to 8 fA/cm² or less. Accordingly, the open-circuit voltage of the cell is increased by 5 mV or more. The P-type silicon substrate is more adaptive to the carriers in the P++ regions than the N-type silicon substrate. The gain in the fill factor of the corresponding cell is 1% or more. As there is no boron diffusion at the low concentration on the front of the present solution, the quantum efficiency of the corresponding cell at the short wavelength is low, and the current is low. The gain in efficiency of the final cell is 0.5% or more.

This embodiment further provides a preparation method for the above P-type TOPCon cell. The preparation method comprises the following steps.

The P-type heavily-doped layers 4, the front passivation layer 3, the front anti-reflection layer 2, and the front metal gate lines 1 are sequentially formed on a front surface of the P-type silicon wafer 5. The doped oxide layer 6, the back crystalline silicon layer 7, the back anti-reflection layer 8, and the back metal electrode layer 9 are sequentially formed on a back surface of the P-type silicon wafer 5. The method for preparing the P++ regions can be any one of current mainstream methods for preparing the SE heavily-doped regions, including, but not limited to, forming the P-type heavily-doped layers 4 by laser doping of boron, boron-paste printing doping, or laser film-cutting boron-diffusion doping. The partially burning-through contact method is applied to the front of the cell, so that the metal contact is only formed at the P++regions to output the current. The method of metallization at the back of the cell can be any one of current mainstream methods, including, but not limited to, the partially burning-through contact method (as shown in the above structural view of the cell) and the back-fully-covering metal-electrode method. The sintering temperature can be in the range of 600 to 1000°C. The front metal gate lines 1 can be formed by the partially burning-through contact method. The back metal gate lines 9 can be formed by the partially burning-through contact method. In an alternative embodiment, a back metal electrode layer fully covering the back, instead of the back metal gate lines 9, can be formed.

As an example, the method for preparing the P-type TOPCon cell comprises the following steps:
texturing on the front surface of the P-type silicon wafer; forming P-type heavily-doped layers (P++ layers) on partial regions of the front surface of the silicon wafer by diffusing a boron compound into the partial regions of the front surface by a method of printing a paste containing the boron compound on the front surface and using laser to facilitate the doping (or other conventional methods for preparing a P-type heavily-doped layer); forming a doped silicon oxide layer and a doped amorphous silicon layer on the back surface of the silicon wafer; preparing an anti-reflection layer containing silicon nitride on the amorphous silicon layer; preparing an aluminum oxide passivation layer on the front surface of the silicon wafer; preparing an anti-reflection layer containing silicon nitride on the aluminum oxide passivation layer; printing a silver-aluminum paste on the front anti-reflection layer to form a front electrode, and printing a silver paste on the back passivation anti-reflection layer to form a back electrode.

In the preparation method of the P-type TOPCon cell of the present application, the form and the shape of the device are not limited, the device can be, for example, a tubular device or a plate device. The manufacturers and the environmental conditions in use of the device are not limited. The geometry, the size, and the shape of the silicon wafer are not limited. The material and the shape of the device supporting the silicon wafer, such as the shape and the size of the graphite boat, are not limited.

In this embodiment, the specific process of preparing the P-type TOPCon cell is as follows.
(1) texturing: a P-type silicon wafer having a resistivity of 0.5 to 1 Ωcm is selected, textured by a 1% KOH alkaline solution, and washed with hydrogen peroxide and an alkaline solution;
(2) preparation of P++ heavily-doped regions: a 100 nm SiO₂ protection layer is grown on a surface of the silicon wafer using a PECVD tubular device; a boron paste is printed corresponding to the metallization pattern; the laser is used to bombard the regions printed with the boron paste to achieve the heavily-doping in partial regions; the doped P++ regions have a sheet resistance of 40 S2/sq;
(3) etching: the SiO₂ protection layer that is wrap-plated on the back surface and the side surfaces of the silicon wafer in PECVD is removed by a chain HF remover, and the silicon wafer is washed with hydrogen peroxide and an alkali solution;
(4) preparation of a back PN junction: a doped oxide layer and a phosphorus-doped amorphous silicon layer is prepared on the back of the cell using a tubular PECVD; the thickness of the oxide layer is 1 to 2 nm, and the thickness of the amorphous silicon layer is 80 nm;
(5) annealing: the cell is annealed in a tubular annealing furnace so that the deposited amorphous silicon layer is crystallized to form a polycrystalline silicon film (poly-Si); the annealing gas atmosphere is nitrogen (N₂); the annealing temperature is 900°C; the annealing time is 20 minutes;
(6) RCA cleaning: the oxidation layer which is wrap-plated on the front surface during the deposition in step 4 and the oxidation layer which is generated during the annealing process are removed by chain hydrofluoric acid (HF), and then the poly layer wrap-plated on the front surface is removed in an alkali bath;
(7) preparation of front passivation and anti-reflection films: a front aluminum oxide (AlOₓ) passivation layer with the thickness of 4 to 6 nm is deposited by a process of atomic layer deposition (ALD) with water; a silicon nitride (SiNₓ) anti-reflection layer with the thickness of 85 to 90 nm is deposited by PECVD; the reflectivity on the front of the cell is 0.9%;
(8) preparation of back film: a SiNₓ film with a thickness of about 70 nm is deposited by PECVD to improve the hydrogen passivation performance of the cell;
(9) metallization: front and back silver electrodes are prepared by a process of screen printing followed by high-temperature (830°C) sintering; and
(10) photo injection, efficiency testing, sorting, and packing.

In the above preparation method, the silicon wafer having a resistivity of 0.5 to 1 Ωcm is selected. The P++ heavily-doped regions are prepared by printing the boron paste. The conventional front and back film/layer preparation method and the metallization method of partially burning-through contact are used. The P-type TOPCon cell prepared has a photoelectric conversion efficiency of above 25.5% ("above" herein means "approximately"), an open-circuit voltage (Voc) of above 732 mV, and a fill factor FF value of above 84%.

### First comparative embodiment

The present comparative embodiment provides an N-type TOPCon cell, which differs from the first embodiment in that in the present comparative embodiment, an N-type silicon wafer is used as a silicon substrate and a fully covering P++ heavily-doped region is prepared in the preparation process.

The N-type TOPCon cell has a photoelectric conversion efficiency of above 24.5%, an open-circuit voltage (Voc) of above 714 mV, and a fill factor FF value of above 82%.

### Second comparative embodiment

The present comparative embodiment provides an N-type TOPCon cell, which differs from the first embodiment in that in the present comparative embodiment, an N-type silicon wafer is used as a silicon substrate.

The N-type TOPCon cell has a photoelectric conversion efficiency of above 25.2%, an open-circuit voltage (Voc) of above 725 mV, and a fill factor FF value of above 83%.

In conclusion, the solar cell and the preparation method thereof in the embodiments of the present application have simple cell structure, short process time, high production capacity, and high cell conversion efficiency.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A solar cell, comprising:
a P-type silicon wafer;
a plurality of P-type heavily-doped layers, a front passivation layer, a front anti-reflection layer, and a plurality of front metal gate lines, which are sequentially disposed on a front surface of the P-type silicon wafer, wherein the plurality of P-type heavily-doped layers are disposed in a plurality of regions corresponding to the plurality of front metal gate lines, respectively, and each of the plurality of front metal gate lines sequentially passes through the front passivation layer, and the front anti-reflection layer to form contact with a corresponding one of the plurality of P-type heavily-doped layers; and
a doped oxide layer, a back crystalline silicon layer, a back anti-reflection layer, and a back metal electrode layer sequentially disposed on a back surface of the P-type silicon wafer.

2. The solar cell according to claim 1, wherein the back metal electrode layer comprises a plurality of back metal gate lines sequentially passing through the back anti-reflection layer, the back crystalline silicon layer, and the doped oxide layer to form contact with the P-type silicon wafer.

3. The solar cell according to claim 1 or 2, wherein the p-type silicon wafer has a resistivity of 0.5 to 10 Ωcm.

4. The solar cell according to any one of claims 1 to 3, wherein the P-type heavily-doped layers have a sheet resistance of 1-120 Ω/sq.

5. The solar cell according to any one of claims 1 to 4, wherein the front anti-reflection layer has a composition comprising at least one of silicon nitride, silicon oxynitride, or silicon oxide.

6. The solar cell according to any one of claims 1 to 5, wherein the front anti-reflection layer has a thickness of 1 to 150 nm.

7. The solar cell according to any one of claims 1 to 6, wherein the back anti-reflection layer has a composition comprising at least one of silicon nitride, silicon oxynitride, or silicon oxide.

8. The solar cell according to any one of claims 1 to 7, wherein the back anti-reflection layer has a thickness of 1 to 100 nm.

9. The solar cell according to any one of claims 1 to 8, wherein the front passivation layer has a composition comprising at least one of aluminum oxide or silicon oxide.

10. The solar cell according to any one of claims 1 to 9, wherein the front passivation layer has a thickness of 1 to 40 nm.

11. The solar cell according to any of claims 1 to 10, wherein the doped oxide layer has a composition comprising silicon oxide.

12. The solar cell according to any one of claims 1 to 11, wherein the doped oxide layer has a thickness of 1 to 2 nm.

13. The solar cell according to any one of claims 1 to 12, wherein the back crystalline silicon layer has a composition comprising polycrystalline silicon or amorphous silicon.

14. The solar cell according to any one of claims 1 to 13, wherein the back crystalline silicon layer has a thickness of 1 to 200 nm.

15. A method for preparing the solar cell according to any one of claims 1 to 14, comprising steps of:
sequentially forming the plurality of P-type heavily-doped layers, the front passivation layer, the front anti-reflection layer, and the plurality of front metal gate lines on the front surface of the P-type silicon wafer, and
sequentially forming the doped oxide layer, the back crystalline silicon layer, the back anti-reflection layer, and the back metal electrode layer on the back surface of the P-type silicon wafer.

16. The method according to claim 15, wherein the P-type heavily-doped layers are formed by laser doping of boron, boron-paste printing doping, or laser film-cutting boron-diffusion doping.

17. The method according to claim 15 or 16, wherein the front metal gate lines are formed in a partially burning-through contact manner.

18. The method according to any one of claims 15 to 17, wherein the back metal electrode layer is formed in a partially burning-through contact manner or a fully covering manner.
